# EUROPÄISCHE PATENTSCHRIFT

(11) **EP 3 369 107 B1**
(45) Veröffentlichungstag und Bekanntmachung des Hinweises auf die Patenterteilung: **04.08.2021**
(21) Anmeldenummer: 16794538.5
(22) Anmeldetag: 25.10.2016
(51) Int. Cl.: H01J 37/32, H03H 7/38

(54) **VERFAHREN ZUR IMPEDANZANPASSUNG EINER LAST AN DIE AUSGANGSIMPEDANZ EINES LEISTUNGSGENERATORS UND IMPEDANZANPASSUNGSANORDNUNG**
METHOD FOR ADJUSTING THE IMPEDANCE OF A LOAD TO THE OUTPUT IMPEDANCE OF A POWER GENERATOR AND IMPEDANCE ADJUSTMENT ASSEMBLY
PROCÉDÉ D'ADAPTATION D'IMPÉDANCE D'UNE CHARGE À L'IMPÉDANCE DE SORTIE D'UN GÉNÉRATEUR DE PUISSANCE ET DISPOSITIF D'ADAPTATION D'IMPÉDANCE

(30) Priorität: 26.10.2015 DE 102015220847
(43) Veröffentlichungstag der Anmeldung: 05.09.2018
(73) Patentinhaber: TRUMPF Hüttinger GmbH + Co. KG, 79111 Freiburg im Breisgau (DE)
(72) Erfinder: MAIER, Florian, 79292 Pfaffenweiler (DE); SCHWERG, Nikolai, 1202 Genève (CH)
(74) Vertreter: Kohler Schmid Möbus Patentanwälte
(86) Internationale Anmeldenummer: PCT/EP2016/075597
(87) Internationale Veröffentlichungsnummer: WO 2017/072087

(56) Entgegenhaltungen:
- JP-A- 2010 041 558
- US-A1- 2005 134 186
- US-A1- 2013 277 333
- US-B1- 6 259 334

## Beschreibung

Die Erfindung betrifft ein Verfahren zur Impedanzanpassung einer Last an die Ausgangsimpedanz eines Leistungsgenerators, sowie eine Impedanzanpassungsanordnung mit zumindest einer über ein Stellglied veränderbaren Reaktanz.

Impedanzanpassungsanordnungen für Hochfrequenzanwendungen, insbesondere Hochfrequenzplasmaanwendungen, dienen dazu, die Impedanz der Last, insbesondere der Plasmalast, so zu transformieren, dass ein Leistungsgenerator die geforderte Wirkleistung an die Last abgeben kann. Dies wird üblicherweise durch Resonanzkreise in T-, L- oder n-(pi)-Topologien mit zwei oder mehr variablen Reaktanzen, die als Kondensatoren und/oder Induktivitäten ausgebildet sein können, erreicht. Die Geschwindigkeit, mit der auf Änderungen der Impedanz der Last reagiert werden kann, wird durch die Dynamik der - üblicherweise mechanisch mit Motoren angetriebenen - variablen Reaktanzen begrenzt.

Bekannt sind solche oder so ähnliche Anordnungen beispielsweise aus einer der folgenden Schriften:
DE 10 2009 001 355 A1, US 2006/0032584 A1, US 2014/0155008 A1, US 2005/134186 A1, US 6 259 334 B1, US 2013/277333 A1 and JP 2010 041558 A.

Aufgabe der vorliegenden Erfindung ist es, ein Verfahren zur Impedanzanpassung und eine Impedanzanpassungsanordnung bereit zu stellen, mit denen eine schnellere Impedanzanpassung durchgeführt werden kann.

Gelöst wird diese Aufgabe erfindungsgemäß durch ein Verfahren zur Impedanzanpassung einer Last an die Ausgangsimpedanz eines Leistungsgenerators gemäß Anspruch 1.

Mit einer Bahnkurve in einer komplexen Lastebene ist ein Kurvenverlauf in einer die Impedanz einer Last beschreibenden Ebene gemeint. Die Ebene zeichnet sich dabei dadurch aus, dass in ihr die Last als Impedanz in komplexer Darstellung darstellbar ist. Die komplexe Lastebene kann beispielsweise sein:
- ein rechtwinkeliges Koordinatensystem mit Realteil und Imaginärteil des Reflexionsfaktors oder der Impedanz der Last oder eines von diesen Werten abhängigen Wertes,
- ein Polarkoordinatensystem mit Phase und Betrag des Reflexionsfaktors oder der Impedanz der Last oder eines von diesen Werten abhängigen Wertes,
- ein Smith-Diagramm, oder
- eine andere vergleichbare ebene Darstellungsform der komplexen Last.

Bei üblichen Plasmaprozesstopologien, bestehend aus einem Leistungsgenerator, insbesondere einem Hochfrequenzgenerator, einer Impedanzanpassungsanordnung und einer Plasmakammer, die ein Plasma als Last aufweist, wird die transformierte Lastimpedanz für den Generator durch Verstimmen von Schwingkreisen, insbesondere von zwei Reihenschwingkreisen, in der Impedanzanpassungsanordnung angepasst. Je nach Bauart und Ausstattung werden die Schwingkreise durch mechanisches, elektromagnetisches oder sonstiges physikalisches Einwirken auf die verwendeten Kondensatoren und Induktivitäten, durch die Änderung der Betriebsfrequenz oder durch das Hinzu- bzw. Fortschalten weiterer Schaltungselemente erreicht. Dabei wird auf die Impedanzanpassungsanordnung in der Regel so eingewirkt, dass die Stellglieder die Reaktanzen so ansteuern, dass die Reaktanzen möglichst schnell einen Wert erreichen, der für eine gute Impedanzanpassung spricht. Auf die Art und Weise, wie der impedanzangepasste Wert erreicht wird, wird in der Regel nicht geachtet. Dies kann dazu führen, dass der Leistungsgenerator während des Anpassungsvorgangs länger bei einem schlechteren Wirkungsgrad/einer ungünstigen Lastbedingung betrieben wird und somit auch länger nicht die geforderte Wirkleistung abgegeben werden kann.

Dadurch, dass erfindungsgemäß eine Bahnkurve unter Berücksichtigung eines vorgegebenen Kriteriums bestimmt wird und die Impedanz der Last entsprechend der Bahnkurve eingestellt wird, kann beispielsweise eine vorgegebene minimale reflektierte Hochfrequenzleistung schneller erreicht werden. Zudem hat dieses Verfahren den weiteren Vorteil, dass eine konstante, präzise stellbare Hochfrequenzprozessenergie zuverlässiger bereitgestellt werden kann. Insbesondere kann somit erreicht werden, dass schon während der Veränderung des Wertes der Reaktanzen die Reflektionsabnahmegeschwindigkeit verbessert ist. Es wird dann nicht, wie im Stand der Technik, im Falle einer Laständerung der direkte Weg vom aktuellen Impedanzwert zum Wert, bei dem ein Reflektionsminimum auftritt, genommen, sondern der Weg bei der die Reflektion zu einem vorgegebenen Zeitpunkt, vorzugsweise zu Beginn, am schnellsten abnimmt, auch dann, wenn der Wert, bei dem ein Reflektionsminimum auftritt, dann erst später erreicht wird.

Beispielsweise kann als Kriterium die Abnahmegeschwindigkeit der reflektierten Leistung, das Erreichen eines vorgegebenen Reflektionsfaktors oder die Effizienz eines Leistungsgenerators vorgegeben werden. Je nach Kriterium kann eine geeignete Bahnkurve ermittelt und können entsprechend die Werte der Reaktanzen angepasst werden.

Weiterhin kann für jede Reaktanz ein einzustellender Wert ermittelt werden, für jede Reaktanz bestimmt werden, mit welcher Verstellgeschwindigkeit der einzustellende Wert erreicht werden soll und die zugeordneten Stellglieder können entsprechend angesteuert werden. Beispielsweise können die zugeordneten Stellglieder so angesteuert werden, dass die Reaktanzen jeweils mit der maximalen Verstellgeschwindigkeit die einzustellenden Werte einnehmen. Alternativ können die zugeordneten Stellglieder so angesteuert werden, dass alle Reaktanzen gleichzeitig den jeweils einzustellenden Wert einnehmen. Außerdem ist es möglich, dass zumindest ein Stellglied so angesteuert wird, dass sich der Wert der zugeordneten Reaktanz mit einer vorgegebenen Verstellgeschwindigkeit ändert und zumindest ein Stellglied so angesteuert wird, dass sich der Wert der zugeordneten Reaktanz mit maximaler Verstellgeschwindigkeit ändert. Bei den Vorgaben, mit welcher Geschwindigkeit eine Reaktanz ihren Wert ändern soll, kann insbesondere auch berücksichtigt werden, welchen maximalen Änderungsbereich die Reaktanz hat und mit welcher Änderungsgeschwindigkeit die Reaktanz überhaupt verändert werden kann. Auch die Charakteristik der einzelnen Stellglieder kann berücksichtigt werden und die Ansteuerung so verbessert werden, dass die Bahnkurve in einer komplexen Lastebene, insbesondere im Smith-Diagramm, schnellstmöglich die reflektierte Leistung (Abstand zum Zentrum der komplexen Lastebene, insbesondere des Smith-Diagramms) reduziert. Dies ist insbesondere dann von Interesse, wenn sich die Dynamik der Stellglieder stark unterscheidet.

In der komplexen Lastebene, insbesondere im Smith-Diagramm, können verbotene Bereiche definiert werden und die Bahnkurve kann so bestimmt werden, dass die verbotenen Bereiche vermieden werden. Beispielsweise können so Bereiche vermieden werden, in denen die Stellglieder eine geringe Dynamik aufweisen.

Gemäß der Erfindung wird ein erster Teil der Bahnkurve nach einem ersten Kriterium und ein zweiter Teil der Bahnkurve nach einem zweiten, anderen Kriterium bestimmt. Beispielsweise kann der erste Teil der Bahnkurve so bestimmt werden, dass ein Reflektionsfaktor oder eine reflektierte Leistung unter einen vorgegebenen Schwellenwert sinkt. Als zweites Kriterium kann dann z.B. vorgegeben werden, dass die Impedanzen in einem Bereich liegen, in dem die Stellglieder eine hohe Dynamik aufweisen oder die Leistungsversorgung eine gute Effizienz aufweist. Weiterhin könnte vorgegeben werden, dass die Endposition der Bahnkurve nicht im Zentrum der komplexen Lastebene, insbesondere des Smith-Diagramms, liegt.

Als mit der reflektierten Leistung in Beziehung stehende Größe kann beispielsweise ein Reflektionsfaktor ermittelt werden. Zur Ermittlung des Reflektionsfaktors können beispielsweise reflektierte Spannung und/oder Strom erfasst werden.

In den Rahmen der Erfindung fällt außerdem eine Impedanzanpassungsanordnung gemäß Anspruch 15. Die Messeinrichtung kann dabei so ausgelegt sein, dass sie die komplexe Spannung und den komplexen Strom, oder die komplexen Wellengrößen für vor- und rücklaufende Welle der Leistung erfasst. Diese Größen können als die mit der reflektierten Leistung in Beziehung stehenden Größen vorgesehen sein. Dadurch, dass eine Bahnkurve in der komplexen Lastebene, insbesondere im Smith-Diagramm, anhand von zumindest einem vorgegebenen Kriterien bestimmt wird, kann ein vorteilhafterer Wert in der komplexen Lastebene, insbesondere im Smith-Diagramm, auf einem "Umweg" erreicht werden, der jedoch andere Vorteile mit sich bringt. Insbesondere kann die vorgesehene Größe in der komplexen Lastebene, insbesondere im Smith-Diagramm, nicht auf direktem Weg erreicht werden, sondern über die zu ermittelnde Bahnkurve.

Dabei kann die Impedanzanpassungsanordnung ausgestaltet sein, die Lastimpedanz am Eingang der Last in eine transformierte Lastimpedanz am Eingang der Impedanzanpassungsanordnung zu wandeln.

Eine besonders schnelle Ermittlung der Bahnkurve kann erfolgen, wenn die Bahnkurvenbestimmungseinheit eine logische Schaltungseinheit, insbesondere ein FPGA (Field Programmable Gate Array), aufweist.

Die Reaktanz kann als Kondensator oder Spule ausgebildet sein. Insbesondere kann die Impedanzanpassungsanordnung mehrere Kondensatoren und/oder Spulen aufweisen. Die Reaktanzen können in unterschiedlichen Schaltungskonfigurationen in der Impedanzanpassungsanordnung vorgesehen sein. Beispielsweise können sie als L- oder n-Schaltung angeordnet sein.

Das Stellglied kann als Motor oder Schaltelement zum Zu- oder Wegschalten einer Reaktanz ausgebildet sein. Als Schaltelement im Sinne der Erfindung werden unter anderem Halbleiterschalter, wie Bipolar oder MOS-Transistoren, Pin-Dioden und Relais verstanden. Auch weitere Schaltelemente sind grundsätzlich denkbar. Darüberhinaus kann die Reaktanz auch durch Änderung der Generatorfrequenz verändert werden.

Eine besonders gute und schnelle Impedanzanpassung kann durchgeführt werden, wenn mehrere Reaktanzen mit zugeordneten Stellgliedern vorgesehen sind.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigt, sowie aus den Ansprüchen. Die dort gezeigten Merkmale sind nicht notwendig maßstäblich zu verstehen und derart dargestellt, dass die erfindungsgemäßen Besonderheiten deutlich sichtbar gemacht werden können. Die verschiedenen Merkmale können je einzeln für sich oder zu mehreren in beliebigen Kombinationen bei Varianten der Erfindung verwirklicht sein.

In der schematischen Zeichnung sind Ausführungsbeispiele der Erfindung dargestellt und in der nachfolgenden Beschreibung näher erläutert.

Es zeigen:
- Fig. 1: eine schematische Darstellung eines Plasmaversorgungssystems;
- Fig. 2: die Effizienz eines Leistungsgenerators über die komplexe Impedanzebene;
- Fig. 3: Konturen konstanter Effizienz auf der komplexen Impedanzebene;
- Fig. 4: Konturen mit konstantem Reflektionsfaktor aufgetragen über Reaktanzwerten;
- Fig. 5a-5c: Geschwindigkeitsprofile für zwei Reaktanzen;
- Fig. 6: einen Reflektionsfaktor über der Zeit.

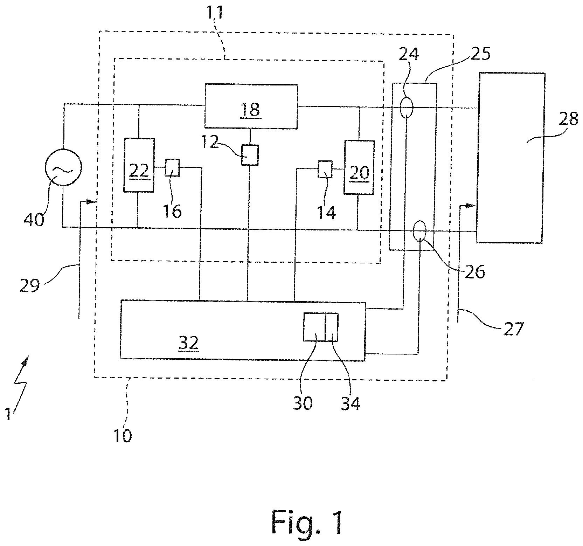

Die Figur 1 zeigt ein Plasmaversorgungssystem 1 mit einem Hochfrequenzleistungsgenerator 40, der über ein Impedanzanpassungsnetzwerk 11 an eine Last 28, insbesondere eine Plasmalast angeschlossen ist. Das Impedanzanpassungsnetzwerk 11 ist Bestandteil einer Impedanzanpassungsanordnung 10. Das Impedanzanpassungsnetzwerk 11 umfasst im gezeigten Ausführungsbeispiel Reaktanzen 18, 20, 22, die jeweils über ein Stellglied 12, 14, 16 angesteuert werden. Die Stellglieder 12, 14, 16 werden durch eine Steuerung 32 angesteuert. Über eine Messeinrichtung 25, die Messglieder 24, 26, beispielsweise zur Erfassung von Strom und Spannung, Vorwärtsleistung und reflektierte Leistung und/oder Impedanzbetrag und Phasenwinkel, aufweisen kann, ist an die Steuerung 32 angeschlossen. Aufgrund der durch die Messeinrichtung 25 ermittelten Größen kann beispielsweise eine an der Last 28 reflektierte Leistung oder ein Reflektionsfaktor ermittelt werden. Eine reflektierte Leistung tritt dann auf, wenn eine Fehlanpassung vorliegt, wenn also die Impedanz der Last 28 nicht an die Ausgangsimpedanz des Leistungsgenerators 40 angepasst ist. Alternativ oder zusätzlich kann eine entsprechende Messeinrichtung auch am Eingang oder innerhalb der Impedanzanpassungsanordnung 10 angeordnet sein. Die Impedanzanpassungsanordnung 10 ist geeignet, die Lastimpedanz 27 am Eingang der Last 18 in eine transformierte Lastimpedanz 29 am Eingang der Impedanzanpassungsanordnung 10, also generatorseitig, zu wandeln.

Über eine Bahnkurvenbestimmungseinheit 30 kann eine Bahnkurve in der komplexen Lastebene, insbesondere im Smith-Diagramm, bestimmt werden. Diese kann so bestimmt werden, dass eine Impedanzanpassung erreicht werden kann. Die Bahnkurvenbestimmungseinheit 30 ist ausgelegt, eine Bahnkurve unter Berücksichtigung zumindest eines vorgegebenen Kriteriums zu ermitteln, beispielsweise um den Reflektionsfaktor möglichst schnell zu reduzieren. Eine schnelle Berechnung bzw. Bestimmung kann erfolgen, wenn die Bahnkurvenbestimmungseinheit eine logische Schaltungseinheit 34, beispielsweise ein FPGA, aufweist. Aufgrund der ermittelten Bahnkurve können die Stellglieder 12, 14, 16 so angesteuert werden, dass die Lastimpedanz der Bahnkurve folgt.

Die Bahnkurven können auf diese Art und Weise verbessert werden. Insbesondere können auch solche Bahnkurven berücksichtigt werden, bei denen kurzzeitig die Reflektion erhöht wird, aber über den gesamten Anpassungsvorgang gemittelt schneller kleinere Reflektionswerte erzielt werden.

Ein Kriterium bei der Bestimmung einer Bahnkurve kann beispielsweise die Effizienz des Leistungsgenerators 40 sein.

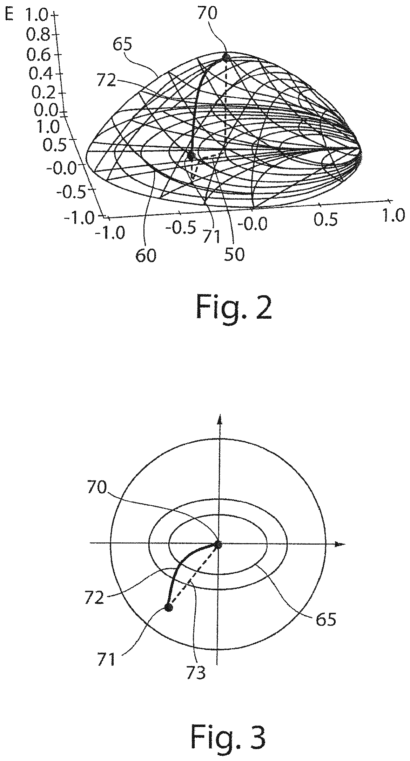

In der Figur 2 ist die Effizienz über einer komplexen Lastebene, in diesem Fall dem Smith-Diagramm 60, aufgetragen, wobei das Maximum 70 der Effizienz in diesem Beispiel im Zentrum des Smith-Diagramms 60 liegt. Dies ist auch anhand der Projektionszeichnung der Figur 3 zu erkennen. Für einen eingezeichneten Lastwechsel von der Stelle 71 zur Stelle 70 entlang der Linie 72 erfolgt bei einer Impedanzanpassung entlang der Bahnkurve 50 eine höhere Effizienzsteigerung und damit eine höhere Leistungsabgabe des Leistungsgenerators 40 als bei einer Impedanzanpassung entlang des direkten Wegs, der beispielsweise in der Figur 3 mit der Bezugsziffer 73 eingezeichnet ist. Als Kriterium für die Bestimmung der Bahnkurve 50 wurde somit hier die Effizienz des Leistungsgenerators 40 herangezogen. Allgemeiner ausgedrückt wurde als Kriterium für die Ermittlung der Bahnkurve 50 eine ausgewählte Charakteristik des Leistungsgenerators 40 herangezogen.

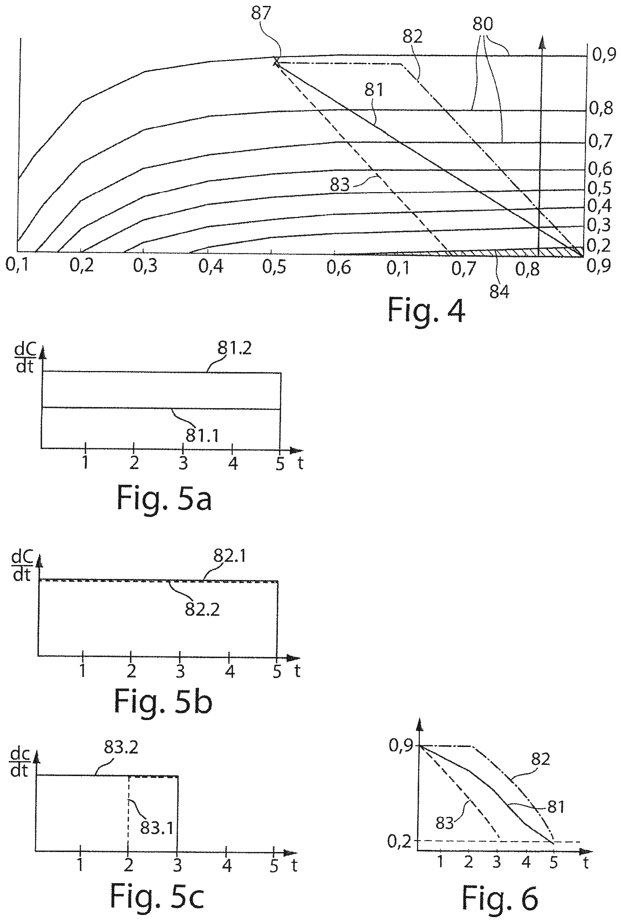

Die Figur 4 zeigt Konturen 80 konstanten Reflektionsfaktors über der Position bzw. Werten zweier Reaktanzen eines exemplarischen Impedanzanpassungsnetzwerks. Auf der horizontalen Achse ist die normierte Größe einer ersten Reaktanz aufgetragen, und auf der vertikalen Achse die normierte Größe einer zweiten Reaktanz. Für eine gegebene Lastimpedanz 27 sind drei verschiedene Bahnkurven 81, 82, 83 zum Anfahren eines Bereichs 84 mit Reflektion < 0,2 dargestellt. Durch die Bahnkurven 81 bis 83 soll somit der Reflektionsfaktor unter einen Schwellenwert, im gezeigten Ausführungsbeispiel unter 0,2, abgesenkt werden. Beginnend am Punkt 87, bei dem die Impedanzanpassungsanordnung 10 einen Betrag des Reflexionsfaktors nahe bei 0,9 verursacht, sollen die Reaktanzen in der Impedanzanpassungsanordnung 10 so verändert werden, dass die transformierte Lastimpedanz 29 in einen Bereich gefahren wird, bei dem der Betrag des Reflexionsfaktors kleiner 0,2 ist. Das kann auf unterschiedlichen Bahnkurven erfolgen. Drei beispielhafte Bahnkurven 81, 82, 83 werden nun erläutert. Die drei Bahnkurven 81, 82, 83 unterscheiden sich dadurch, mit welcher Verstellgeschwindigkeit jeweils die Reaktanzen des Impedanzanpassungsnetzwerks geändert werden. Dies ist anhand der Figuren 5a - 5c erläutert. Auf der horizontalen Achse ist die Zeit aufgetragen, auf der vertikalen Achse die Änderung der Reaktanz, z.B. der Kapazität, über der Zeit.

Die Bahnkurve 81 wird gemäß Fig. 5a dadurch erreicht, dass die beiden Reaktanzen, z.B. Kondensatoren, mit konstanter Verstellgeschwindigkeit verstellt werden, wobei die erste Reaktanz gemäß der Linie 81.1 mit einer Geschwindigkeit geringer als der maximalen Verstellgeschwindigkeit verändert wird, während die zweite Reaktanz gemäß der Linie 81.2 mit ihrer maximalen Verstellgeschwindigkeit verändert wird. Im gewählten Ausführungsbeispiel weisen beide Reaktanzen die gleiche maximale Verstellgeschwindigkeit auf.

Die Bahnkurve 82 wird gemäß Fig. 5b dadurch erreicht, dass beide Reaktanzen mit ihrer maximalen Verstellgeschwindigkeit verändert werden, bis sie ihren Endpunkt (bei 5 Sek.) erreicht haben, d.h. der Sollwert erreicht ist. Obwohl die Reaktanzen für die Bahnkurven 81 und 82 unterschiedlich angesteuert erden, erreichen sie etwa zu demselben Zeitpunkt den Sollwert.

Die Bahnkurve 83 wird gemäß Fig. 5c erreicht, indem zunächst nur die zweite Reaktanz mit maximaler Geschwindigkeit verändert wird. Zum Zeitpunkt 2 Sek. wird zusätzlich die erste Reaktanz mit maximaler Geschwindigkeit verändert, so dass zum Zeitpunkt 3 Sek. beide Reaktanzen gleichzeitig ihren Sollwert erreichen. Dies ist durch die Linien 83.1 und 83.2 in der Figur 5c dargestellt.

Die Figur 6 zeigt ein Diagramm zur Erläuterung der Impedanzanpassgeschwindigkeit. Auf der horizontalen Achse ist die Zeit aufgetragen, auf der vertikalen Achse der Betrag des Reflexionsfaktors. Hier ist zu erkennen, dass die Bahnkurve 83 nach der kürzesten Zeit, d.h. mit der schnellsten Impedanzanpassgeschwindigkeit einen Reflektionsfaktor von < 0,2 erreicht. Die Bahnkurven 81, 82 führen dazu, dass zu einem späteren Zeitpunkt ein Reflektionsfaktor < 0,2 erreicht wird. Hieraus ist zu erkennen, dass eine Ansteuerung der Reaktanzen gemäß der Bahnkurve 83 am schnellsten zu einem geringen Reflektionsfaktor führt.

## Patentansprüche

1. Verfahren zur Impedanzanpassung einer Last (28) an die Ausgangsimpedanz eines Leistungsgenerators (40), mit den Verfahrensschritten:
a. Generieren einer Leistung mittels eines Leistungsgenerators (40);
b. Zuführen der Leistung an eine Last (28) über eine Impedanzanpassungsanordnung (10) mit zumindest einer über ein Stellglied (12, 14, 16) veränderbaren Reaktanz (18, 20, 22), wobei die Impedanzanpassungsanordnung (10) die Lastimpedanz (27) am Eingang der Last (18) in eine transformierte Lastimpedanz (29) am Eingang der Impedanzanpassungsanordnung (10) wandelt;
c. Erfassen oder Bestimmen einer an der Last (28) reflektierten Leistung oder mindestens einer damit in Beziehung stehenden Größe;
d. Anhand der reflektierten Leistung oder der mindestens einen damit in Beziehung stehenden Größe, Überprüfen, ob eine Fehlanpassung vorliegt; **gekennzeichnet durch**
e. Bestimmen einer Bahnkurve (50) in einer komplexen Lastebene, insbesondere Smith-Diagramm (60), nach zumindest einem vorgegebenen Kriterium;
f. Steuerung des zumindest einen Stellglieds (12, 14, 16) so, dass die transformierte Lastimpedanz der Bahnkurve (50) folgt, wobei ein erster Teil der Bahnkurve (50) nach einem ersten Kriterium und ein zweiter Teil der Bahnkurve (50) nach einem zweiten, anderen Kriterium bestimmt wird.

2. Verfahren nach Anspruch 1, **dadurch gekennzeichnet, dass** die Bahnkurve in einer komplexen Lastebene einen Kurvenverlauf in einer die Impedanz einer Last beschreibenden Ebene darstellt, wobei die Ebene sich dabei dadurch auszeichnet, dass in ihr die Last als Impedanz in komplexer Darstellung darstellbar ist.

3. Verfahren nach einem der vorhergehenden Ansprüche, **dadurch gekennzeichnet, dass** als Kriterium die Abnahmegeschwindigkeit der reflektierten Leistung, das Erreichen eines vorgegebenen Reflexionsfaktors oder die Effizienz des Leistungsgenerators (40) vorgegeben werden.

4. Verfahren nach einem der vorhergehenden Ansprüche, **dadurch gekennzeichnet, dass** für jede Reaktanz (18, 20, 22) ein einzustellender Wert ermittelt wird, für jede Reaktanz (18, 20, 22) bestimmt wird, mit welcher Verstellgeschwindigkeit der einzustellende Wert erreicht werden soll und die zugeordneten Stellglieder (12, 14, 16) entsprechend angesteuert werden.

5. Verfahren nach Anspruch 4, **dadurch gekennzeichnet, dass** die zugeordneten Stellglieder (12, 14, 16) so angesteuert werden, dass die Reaktanzen (18, 20, 22) jeweils mit der maximalen Verstellgeschwindigkeit den einzustellenden Wert einnehmen.

6. Verfahren nach Anspruch 4, **dadurch gekennzeichnet, dass** die zugeordneten Stellglieder (12, 14, 16) so angesteuert werden, dass alle Reaktanzen (18, 20, 22) gleichzeitig den jeweils einzustellenden Wert einnehmen.

7. Verfahren nach Anspruch 4, **dadurch gekennzeichnet, dass** zumindest ein Stellglied (12, 14, 16) so angesteuert wird, dass sich der Wert der zugeordneten Reaktanz (18, 20, 22) mit einer vorgegebenen Verstellgeschwindigkeit ändert und zumindest ein Stellglied (12, 14, 16) so angesteuert wird, dass sich der Wert der zugeordneten Reaktanz (18, 20, 22) mit maximaler Verstellgeschwindigkeit ändert.

8. Verfahren nach einem der vorhergehenden Ansprüche, **dadurch gekennzeichnet, dass** bei der Vorgabe, mit welcher Geschwindigkeit eine Reaktanz ihren Wert ändern soll, der maximale Änderungsbereich der Reaktanz und die maximale Änderungsgeschwindigkeit der Reaktanz mit berücksichtigt werden.

9. Verfahren nach einem der vorhergehenden Ansprüche, **dadurch gekennzeichnet, dass** die Charakteristik der zugeordneten Stellglieder berücksichtigt wird und die Ansteuerung so eingestellt wird, dass die Bahnkurve in einer komplexen Lastebene, insbesondere im Smith-Diagramm, schnellstmöglichst die reflektierte Leistung reduziert.

10. Verfahren nach Anspruch 9, **dadurch gekennzeichnet, dass** sich die Dynamik der zugeordneten Stellglieder wesentlich unterscheidet.

11. Verfahren nach einem der vorhergehenden Ansprüche, **dadurch gekennzeichnet, dass** in der komplexen Lastebene, insbesondere im Smith-Diagramm (60), verbotene Bereiche definiert werden und die Bahnkurve (50) so bestimmt wird, dass die verbotenen Bereiche vermieden werden.

12. Verfahren nach einem der vorhergehenden Ansprüche, **dadurch gekennzeichnet, dass** der erste Teil der Bahnkurve so bestimmt wird, dass ein Reflektionsfaktor oder eine reflektierte Leistung unter einen vorgegebenen Schwellenwert sinkt.

13. Verfahren nach einem der vorhergehenden Ansprüche, **dadurch gekennzeichnet, dass** als zweites Kriterium vorgegeben wird, dass die Impedanz in einem Bereich liegt, in dem die Stellglieder eine hohe Dynamik aufweisen oder die Leistungsversorgung eine gute Effizienz aufweist.

14. Verfahren nach einem der vorhergehenden Ansprüche 1-12, **dadurch gekennzeichnet, dass** als zweites Kriterium vorgegeben wird, dass die Endposition der Bahnkurve nicht im Zentrum der komplexen Lastebene, insbesondere des Smith-Diagramms, liegt.

15. Impedanzanpassungsanordnung (10) mit zumindest einer über ein Stellglied (12, 14, 16) veränderbaren Reaktanz (18, 20, 22), einer Messeinrichtung (25) konfiguriert zur Erfassung der an einer Last (28) reflektierten Leistung oder mindestens einer damit in Beziehung stehenden Größe, **gekennzeichnet durch** eine Bahnkurvenbestimmungseinheit (30), die ausgebildet ist aufgrund der erfassten reflektierten Leistung oder der damit in Beziehung stehenden Größe und zumindest einem vorgegebenen Kriterium eine Bahnkurve (50) in einer komplexen Lastebene, insbesondere im Smith-Diagramm (60), zu bestimmen, sowie einer Steuerung (32), die ausgebildet ist das zumindest eine Stellglied (12, 14, 16) entsprechend der bestimmten Bahnkurve (50) anzusteuern, wobei die Bahnkurvenbestimmungseinheit (30) weiter ausgebildet ist ein erster Teil der Bahnkurve (50) nach einem ersten Kriterium und ein zweiter Teil der Bahnkurve (50) nach einem zweiten, anderen Kriterium zu bestimmen.

## Claims

1. Method for matching the impedance of a load (28) to the output impedance of a power generator (40), comprising the following method steps:
a. generating power by means of a power generator (40);
b. supplying the power to a load (28) by means of an impedance matching arrangement (10) comprising at least one reactance (18, 20, 22) which can be adjusted by an actuator (12, 14, 16), wherein the impedance matching arrangement (10) transforms the load impedance (27) at the input end of the load (18) into a transformed load impedance (29) at the input end of the impedance matching arrangement (10);
c. detecting or determining power reflected at the load (28), or at least one variable related thereto;
d. checking, on the basis of the reflected power or the at least one variable related thereto, whether there is a mismatch; **characterized by**
e. determining a trajectory (50) in a complex load plane, in particular in a Smith chart (60), according to at least one specified criterion;
f. controlling the at least one actuator (12, 14, 16) such that the transformed load impedance follows the trajectory (50), wherein a first part of the trajectory (50) is determined according to a first criterion and a second part of the trajectory (50) is determined according to a second different criterion.

2. Method according to claim 1, **characterised in that** the trajectory in a complex load plane is a curve in a plane which describes the impedance of a load, the plane being **characterised in that** the load can be shown as impedance in a complex manner therein.

3. Method according to either of the preceding claims, **characterised in that** the speed of reduction in the reflected power, achievement of a specified reflection coefficient or the efficiency of the power generator (40) are specified as the criterion.

4. Method according to any of the preceding claims, **characterised in that** a value to be set is determined for each reactance (18, 20, 22), the adjustment speed at which the value to be set should be achieved is determined for each reactance (18, 20, 22), and the associated actuators (12, 14, 16) are correspondingly controlled.

5. Method according to claim 4, **characterised in that** the associated actuators (12, 14, 16) are controlled such that each reactance (18, 20, 22) takes on the value to be set at the maximum adjustment speed.

6. Method according to claim 4, **characterised in that** the associated actuators (12, 14, 16) are controlled such that all the reactances (18, 20, 22) simultaneously take on the particular value to be set.

7. Method according to claim 4, **characterised in that** at least one actuator (12, 14, 16) is controlled such that the value of the associated reactance (18, 20, 22) changes at a specified adjustment speed, and at least one actuator (12, 14, 16) is controlled such that the value of the associated reactance (18, 20, 22) changes at the maximum adjustment speed.

8. Method according to any of the preceding claims, **characterised in that** the maximum adjustment range of the reactance and the maximum adjustment speed of the reactance are taken into consideration when specifying the speed at which a reactance should change the value thereof.

9. Method according to any of the preceding claims, **characterised in that** the characteristic of the associated actuators is taken into consideration, and the controlling is adjusted, such that the trajectory in a complex load plane, in particular in the Smith chart, reduces the reflected power as quickly as possible.

10. Method according to claim 9, **characterised in that** the dynamics of the associated actuators are significantly different from one another.

11. Method according to any of the preceding claims, **characterised in that**, in the complex load plane, in particular in the Smith chart (60), forbidden ranges are defined, and the trajectory (50) is determined such that the forbidden ranges are avoided.

12. Method according to any of the preceding claims, **characterised in that** the first portion of the trajectory is determined such that a reflection coefficient or a reflected power fall below a specified threshold value.

13. Method according to any of the preceding claims, **characterised in that** as the second criterion it is specified that the impedance must be within a range in which the actuators have high dynamics or in which the power supply has good efficiency.

14. Method according to any of the preceding claims 1 to 12, **characterised in that** as the second criterion it is specified that the end position of the trajectory is not in the centre of the complex load plane, in particular of the Smith chart.

15. Impedance matching arrangement (10) comprising at least one reactance (18, 20, 22) which can be adjusted by an actuator (12, 14, 16), a measurement device (25) configured to detect the power reflected at a load (28) or at least one variable related thereto, **characterized by** a trajectory determining unit (30) which is designed to determine a trajectory (50) in a complex load plane, in particular in the Smith chart (60), on the basis of the detected reflected power or the variable related thereto and at least one specified criterion, and a controller (32) which is designed to control the at least one actuator (12, 14, 16) according to the determined trajectory (50), wherein the trajectory determining unit (30) is further designed to determine a first portion of the trajectory (50) according to a first criterion, and a second portion of the trajectory (50) according to a second, different criterion.

## Revendications

1. Procédé d'adaptation d'impédance d'une charge (28) à l'impédance de sortie d'un générateur de puissance (40), ledit procédé comprenant les étapes suivantes :
a. générer une puissance à l'aide d'un générateur de puissance (40) ;
b. amener la puissance à une charge (28) par le biais d'un dispositif d'adaptation d'impédance (10) comprenant au moins un composant à réactance (18, 20, 22) dont la réactance peut être modifiée par le biais d'un actionneur (12, 14, 16), le dispositif d'adaptation d'impédance (10) convertissant l'impédance de charge (27) à l'entrée de la charge (18) en une impédance de charge transformée (29) à l'entrée du dispositif d'adaptation d'impédance (10) ;
c. détecter ou déterminer une puissance réfléchie au niveau de la charge (28) ou au moins une grandeur liée à celle-ci ;
d. sur la base de la puissance réfléchie ou l'au moins une grandeur liée à celle-ci, vérifier s'il y a une désadaptation ; **caractérisé par** les étapes suivantes
e. déterminer une trajectoire (50) dans un plan de charge complexe, notamment un diagramme de Smith (60), selon au moins un critère spécifié ;
f) commander l'au moins un actionneur (12, 14, 16) de sorte que l'impédance de charge transformée suive la trajectoire (50), une première partie de la trajectoire (50) étant déterminée selon un premier critère et une deuxième partie de la trajectoire (50) étant déterminée selon un deuxième critère différent.

2. Procédé selon la revendication 1, **caractérisé en ce que** la trajectoire dans un plan de charge complexe représente une allure de trajectoire dans un plan décrivant l'impédance d'une charge, le plan étant **caractérisé par le fait que** la charge peut y être représentée comme une impédance dans une représentation complexe.

3. Procédé selon l'une des revendications précédentes, **caractérisé en ce que** le critère spécifié est la vitesse à laquelle la puissance réfléchie diminue, le moment où un facteur de réflexion spécifié est atteint ou le rendement du générateur de puissance (40).

4. Procédé selon l'une des revendications précédentes, **caractérisé en ce qu'**une valeur à régler est déterminée pour chaque composant à réactance (18, 20, 22), et on détermine pour chaque composant à réactance (18, 20, 22) la vitesse de réglage à laquelle la valeur à régler doit être atteinte et les actionneurs associés (12, 14, 16) sont commandés en conséquence.

5. Procédé selon la revendication 4, **caractérisé en ce que** les actionneurs associés (12, 14, 16) sont commandés de telle sorte que les composants à réactance (18, 20, 22) prennent chacun la valeur à régler à la vitesse de réglage maximale.

6. Procédé selon la revendication 4, **caractérisé en ce que** les actionneurs associés (12, 14, 16) sont commandés de telle sorte que tous les composants à réactance (18, 20, 22) prennent simultanément la valeur de réactance à régler respective.

7. Procédé selon la revendication 4, **caractérisé en ce qu'**au moins un actionneur (12, 14, 16) est commandé de telle sorte que la valeur de réactance du composant à réactance associé (18, 20, 22) varie à une vitesse de réglage spécifiée et au moins un actionneur (12, 14, 16) est commandé de telle sorte que la valeur de réactance du composant à réactance associée (18, 20, 22) varie à la vitesse de réglage maximale.

8. Procédé selon l'une des revendications précédentes, **caractérisé en ce que**, lors de la spécification de la vitesse à laquelle la valeur de réactance doit varier, la plage de variation maximale de la valeur de réactance et la vitesse de variation maximale de la valeur de réactance sont également prises en compte.

9. Procédé selon l'une des revendications précédentes, **caractérisé en ce que** les caractéristiques des actionneurs associés sont prises en compte et la commande est réglée de telle sorte que la trajectoire dans un plan de charge complexe, notamment dans le diagramme de Smith, réduise la puissance réfléchie le plus rapidement possible.

10. Procédé selon la revendication 9, **caractérisé en ce que** les dynamiques des actionneurs associés diffèrent sensiblement.

11. Procédé selon l'une des revendications précédentes, **caractérisé en ce que** des zones interdites sont définies dans le plan de charge complexe, notamment dans le diagramme de Smith (60) et la trajectoire (50) est déterminée de telle sorte que les zones interdites soient évitées.

12. Procédé selon l'une des revendications précédentes, **caractérisé en ce que** la première partie de la trajectoire est déterminée de telle sorte qu'un facteur de réflexion ou une puissance réfléchie tombe au-dessous d'une valeur seuil spécifiée.

13. Procédé selon l'une des revendications précédentes, **caractérisé en ce qu'**il est spécifié comme deuxième critère que l'impédance est dans une plage dans laquelle les actionneurs ont une dynamique élevée ou l'alimentation en puissance a un bon rendement.

14. Procédé selon l'une des revendications précédentes 1 à 12, **caractérisé en ce qu'**il est spécifié comme deuxième critère que la position finale de la trajectoire n'est pas au centre du plan de charge complexe, notamment du diagramme de Smith.

15. Dispositif d'adaptation d'impédance (10) comprenant au moins un composant à réactance (18, 20, 22) dont la réactance peut être modifiée par le biais d'un actionneur (12, 14, 16), un moyen de mesure (25) conçu pour détecter la puissance réfléchie au niveau d'une charge (28) ou au moins une grandeur liée à celle-ci, **caractérisé par** une unité de détermination de trajectoire (30) qui est conçue pour déterminer, sur la base de la puissance réfléchie détectée ou de la grandeur liée à celle-ci et d'au moins un critère spécifié, une trajectoire (50) dans un plan de charge complexe, notamment dans le diagramme de Smith (60),
ainsi qu'une commande (32) qui est conçue pour commander l'au moins un actionneur (12, 14, 16) selon la trajectoire déterminée (50),
l'unité de détermination de trajectoire (30) étant en outre conçue pour déterminer une première partie de la trajectoire (50) selon un premier critère et une deuxième partie de la trajectoire (50) selon un deuxième critère différent.
